# EUROPEAN PATENT APPLICATION

(11) **EP 4 541 638 A1**
(43) Date of publication of application: **23.04.2025**
(21) Application number: 23203771.3
(22) Date of filing: 16.10.2023
(51) Int. Cl.: B60L 50/60, B60R 16/023

(54) **A METHOD FOR OPERATING A SWITCHING ARRANGEMENT OF AN ENERGY STORAGE SYSTEM IN A VEHICLE**

(71) Applicant: VOLVO TRUCK CORPORATION, 405 08 Göteborg (SE)
(72) Inventor: NORDHOLM, Linus, 43640 ASKIM (SE); SMIDEBRANT, Tobias, 415 51 GÖTEBORG (SE); WILHELMSSON, Martin, 423 39 TORSLANDA (SE)
(74) Representative: Kransell & Wennborg KB

(57) **Abstract**

A computer system comprising processing circuitry configured to:
- determine measured current over each one of a plurality of contactors of a switching arrangement of an energy storage system of a vehicle,
- determine a health level of each contactor,
- control the order in which the battery packs are disconnected from the common traction voltage bus, until all of the battery packs are disconnected, by opening closed contactors according to the following:
- open the closed contactor having the lowest measured current in response to that no closed contactor has a health level deviating from a mean health level of all contactors with more than a first predetermined value, and
- open the closed contactor having the lowest health level in response to that the health level of such closed contactor deviates from the mean health level of all contactors with a value of more than the first predetermined value.

## Description

### TECHNICAL FIELD

The disclosure relates generally to operating management of battery packs in an energy storage system of a vehicle. In particular aspects, the disclosure relates to a method for controlling a switching arrangement of an energy storage system of a vehicle. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

A vehicle typically comprises an engine for propelling the vehicle. The engine may be an internal combustion engine powered by e.g. liquid or gaseous fuel, or it may be an electric machine powered by electricity. Moreover, hybrid solutions exist in which the vehicle is propelled both by an internal combustion engine and an electric machine. In either way, an energy storage device is used to store the energy needed in order to propel the vehicle. Energy storage devices may further be used to power auxiliary loads in the vehicle.

For many vehicles, the energy storage devices are comprised in an energy storage system, wherein the energy storage system is configured to power the electric machine for propelling the vehicle, as well as any auxiliary load. For example, for an electric vehicle, the energy storage devices may be batteries or battery packs, which are configured to operate the electric machine as well as electrically driven auxiliary equipment. The electric machine and/or the electrically driven auxiliary equipment may be commonly referred to as a load. Several batteries, or several series-connected and/or parallel connected battery cells, may be grouped into the battery pack. The battery pack is periodically in need of charging, and is then electrically connected to an electrical energy source, e.g. via plug directly connected to the power grid, or by an on-board charger. Such chargers may commonly be referred to as a power source.

In many applications, several battery packs are included in the energy storage system by being parallelly connected to a common traction voltage bus (or common traction power bus), sometimes referred to as multi-battery pack system. The load and/or power source is also connected to the common traction voltage bus. Hereby, the supplied power can be adapted based on the number of battery packs, and/or higher power requirements of the vehicle may be met. Typically, each battery pack is associated with a switch, or contactor, enabling connection and disconnection of the battery pack relative the common traction voltage bus and the load and/or power source. However, every time the state of a contactor is changed from closed to open, or vice versa, the contactor is subject to mechanical and electrical wear in the form of contactor wear.

Contactor wear as described above may lead to contactor failure. In particular, premature contactor failure of a single contactor is undesirable, as sometimes more than the failing contactor have to be replaced, which may be very cumbersome.

### SUMMARY

According to a first aspect of the disclosure, computer system comprising processing circuitry is provided. The processing circuitry is configured to: determine measured current over each one of a plurality of contactors of a switching arrangement of an energy storage system of a vehicle, the energy storage system comprising at least two parallelly arranged battery packs and each contactor is configured to connect and disconnect an associated battery pack of the energy storage system to and from a common traction voltage bus by closing and opening, respectively; determine a health level of each contactor; control the order in which the battery packs are disconnected from the common traction voltage bus, until all of the battery packs are disconnected, by opening closed contactors according to the following: open the closed contactor having the lowest measured current in response to that no closed contactor has a health level deviating from a mean health level of all contactors with more than a first predetermined value, and open the closed contactor having the lowest health level in response to that the health level of such closed contactor deviates from the mean health level of all contactors with a value of more than the first predetermined value, and in response to that no closed contactor has a measured current deviating from a mean measured current of all contactors with more than a second predetermined value.

The first aspect of the disclosure may seek to overcome problems relating to decreased life-length of the contactors, and/or single contactor failure, as the control of the order in which the battery packs are disconnected from the common traction voltage bus, until all of the battery packs are disconnected, is performed in response to the measured current and the health level of the contactors. Thus, the order in which the contactors are opened may be controlled in response to the health level and the measured current of the contactors, resulting in an improved operation of which, and when, the different closed contactors are to be opened. Hereby, the risk of a single contactor failure, or at least premature single contactor failure, is reduced. Thus, maintenance of the contactor, or contactor exchange, may be performed less frequently. A technical benefit of the first aspect of the disclosure may thus include increased life-length of the contactors and/or decreased risk of single contactor failure. That is, by using both the measured current and the health level of the contactors when determining in which order the closed contactors are opened, an improved operation of disconnecting the battery packs from the common traction voltage bus, until all of the battery packs are disconnected, is achieved. It should be noted that the measured current over each one of the plurality of contactors is referring to the current over the corresponding contactor prior to, or just prior to contactor opening. The plurality of contactors may thus be referring to a plurality of closed contactors of the switching arrangement.

Optionally in some examples, including in at least one preferred example, the processing circuitry is configured to determine the health level of each contactor as the general health level of the contactor. A technical benefit may include an improved determination of the health level, and an improved operation of which, and when, the different closed contactors are to be opened with regards to e.g. reducing the risk of single contactor failure. The general health level of the contactor may be referred to as the complete, full, absolute or total health level of the contactor.

Optionally in some examples, including in at least one preferred example, the processing circuitry is configured to determine the health level of each contactor by a scale of 0 % to 100 %. A technical benefit may include an improved determination of the health level, and an improved operation of which, and when, the different closed contactors are to be opened with regards to reducing the risk of single contactor failure. For example, 0 % health level may correspond to an indefectible contactor. An indefectible contactor may also be referred to as an unworn, fresh, new or unused contactor. Correspondingly, 100 % health level may correspond to a contactor which is deemed to be exchanged, or subject to maintenance. A contactor having a health level of 100 %, or a contactor deemed to be exchanged, may thus be functional but considered to have reached a predetermined threshold for which the operation of the contactor no longer is reliable. Thus, the contactor may still be operated at a health level of 100 %, and the health level increase may still be accounted for, e.g. to an overdue health level of 20 % (i.e. a corresponding health level of 120 %). As an alternative, a contactor having a health level of 100 % may correspond to a contactor which is non-functional. According to an alternative example, 100 % health level may correspond to an indefectible contactor. Correspondingly, 0 % health level may correspond to a contactor which is deemed to be exchanged, or subject to maintenance. A contactor having a health level of 0 %, or a contactor deemed to be exchanged, may thus be functional but considered to have reached a predetermined threshold for which the operation of the contactor no longer is reliable.

Optionally in some examples, including in at least one preferred example, the processing circuitry is configured to determine the health level of each contactor by its total operation time, its total number of contactor openings or a combination thereof. For example, a health level of 0 % may correspond to a total operation time of 0 h, or a total number of contactor openings of 0. Correspondingly, a health level of 100 % may correspond to a total operation time, or total number of contactor openings, for which the contactor is deemed to be exchanged, e.g. 1000 h or corresponding to e.g. 100000 contactor openings, or nominal contactor openings. As an alternative, the health level is set to the actual total operation time (i.e. in hours) and/or the total number of contactor openings. However, the health level of the contactors can be calculated or estimated by other means. Optionally in some examples, including in at least one preferred example, the processing circuitry is configured to determine the health level of each contactor by the total number of openings and the current at which the opening occurred (i.e. the current just prior to the contactor opening). For example, a contactor opening at a higher current imposes a larger change in the health level as compared to a contactor opening at a lower current, as contactor opening at the higher current imposes a larger contactor wear.

Optionally in some examples, including in at least one preferred example, the processing circuitry is configured to further control the order in which the battery packs are disconnected from the common traction voltage bus, until all of the battery packs are disconnected, by opening the closed contactors according to the following: in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, open the first closed contactor or the second closed contactor. A technical benefit may include an improved operation of the order in which the closed contactors are to be opened with regards to e.g. reducing the risk of single contactor failure.

Optionally in some examples, including in at least one preferred example, the processing circuitry is configured to open the first closed contactor prior the second closed contactor in response to that the health level of the first closed contactor deviates from the mean health level of all contactors with a percentage rate higher than the deviation of the measured current of the second closed contactor from the mean measured current of all contactors. A technical benefit may include an improved operation of the order in which the closed contactors are to be opened with regards to e.g. reducing the risk of single contactor failure. Thus, for a scenario in which the first closed contactor has the lowest health level and that the health level of the first closed contactor deviates from the mean health level of all contactors with a value of more than the first predetermined value, and that the second closed contactor has the lowest measured current and that the measured current of the second closed contactor deviates from the mean measured current of all contactors with more than the second predetermined value, a weighting between the health level and the measured current is provided.

Optionally in some examples, including in at least one preferred example, the processing circuitry is configured to open the second closed contactor prior the first closed contactor in response to that the measured current of the second closed contactor deviates from the mean measured current of all contactors with a percentage rate higher than the deviation of the health level of the first closed contactor from the mean health level of all contactors. A technical benefit may include an improved operation of the order in which the closed contactors are to be opened with regards to e.g. reducing the risk of single contactor failure. Thus, for a scenario in which the first closed contactor has the lowest health level and that the health level of the first closed contactor deviates from the mean health level of all contactors with a value of more than the first predetermined value, and that the second closed contactor has the lowest measured current and that the measured current of the second closed contactor deviates from the mean measured current of all contactors with more than the second predetermined value, a weighting between the health level and the measured current is provided.

Optionally in some examples, including in at least one preferred example, the processing circuitry is further configured to: receive measurement data from a plurality of sensors of the energy storage system, wherein the measurement data comprises measured current over each one of a plurality of contactors. A technical benefit may include usage of reliable data and efficient handling and communication of data. The plurality of sensors may e.g. include a current sensor and/or a voltage sensor for each one of the contactors. Such current sensor is typically arranged to directly measure the current, or the current may be indirectly measured by the voltage sensor, over the corresponding contactor. Thus, the processing circuitry may be configured to measure the current over each one of the plurality of contactors. Thus, the measured current may correspond to the previously mentioned determined measured current.

Optionally in some examples, including in at least one preferred example, the processing circuitry is further configured to repeat determining the measured current over each one of a plurality of contactors prior to each opening of a contactor. A technical benefit may include improved operation of the contactors over time.

Optionally in some examples, including in at least one preferred example, the processing circuitry is further configured to: identify a at least two parallelly arranged battery packs connected to the common traction voltage bus of the energy storage system, and identify the associated contactors to the parallelly arranged battery packs, wherein controlling the order in which the closed contactors are opened is performed for all of the identified parallelly arranged battery packs until no battery pack is connected to the common traction voltage bus. A technical benefit may include improved accuracy of the contactors being subject to the controlled operation.

Optionally in some examples, including in at least one preferred example, the processing circuitry is further configured to: subsequent to controlling the order in which the closed contactors are opened, connect at least two of the battery packs to the common traction voltage bus by closing the associated contactors, and thereafter: alternately connect and disconnect the battery packs from and to the common traction voltage bus, wherein said controlling of the order in which the closed contactors are opened is performed for each disconnection. A technical benefit may include improved operation of the contactors over time.

Optionally in some examples, including in at least one preferred example, the processing circuitry is configured to: determine the mean health level of all closed contactors. A technical benefit may include improved determination of whether a closed contactor deviates from the mean health level with a value of more than the first predetermined value. The mean health level may e.g. be determined by the ratio of the sum of the health level for all closed contactors, and the number of closed contactors for which the health level is determined.

Optionally in some examples, including in at least one preferred example, the first predetermined value is at least 1 %, or at least 3 %, or at least 5 %, or at least 10 %. The percentage of the first predetermined value may refer to absolute percentage, or percentage points, corresponding to the health level of the contactors (i.e. for embodiment in which the health level is determined by a scale of 0 % to 100 %), or it may refer to relative percentage corresponding to the percent difference of the quantity being set for the health level. That is, the relative percentage may refer to the relative change or the change in the health level in percentage terms, i.e. absolute change as a percentage of the value of the unit for the health level. The processing circuitry may thus be configured to: open the closed contactor having the lowest measured current in response to that no closed contactor has a health level deviating from the mean health level of all contactors with more than 1 %, or 3 %, or 5 %, or 10 %.

Optionally in some examples, including in at least one preferred example, the processing circuitry is configured to: determine the mean measured current of all closed contactors. A technical benefit may include improved determination of whether a closed contactor deviates from the mean measured current with a value of more than the second predetermined value. The mean measured current may e.g. be determined by the ratio of the sum of the measured current for all closed contactors, and the number of closed contactors for which the current is measured.

Optionally in some examples, including in at least one preferred example, the second predetermined value is at least 1 %, or at least 3 %, or at least 5 %, or at least 10 %. The percentage of the second predetermined value may refer to relative percentage corresponding to the percent difference of the quantity being measured for the current, i.e. Amperes. That is, the relative percentage may refer to the relative change or the change in Amperes in percentage terms, i.e. absolute change in measured current as a percentage. The processing circuitry may thus be configured to: open the closed contactor having the lowest health level in response to that the health level of such closed contactor deviates from the mean health level of all contactors with a value of more than the first predetermined value (or with more than 1 %, or 3 %, or 5 %, or 10 %), and in response to that no measured current deviates from a mean measured current of all contactors with more than 1 %, or 3 %, or 5 %, or 10 %. As an alternative, the second predetermined value is expressed in Amperes instead of percentage. For example, the second predetermined value is at least 10 mA, or at least 100 mA or at least 1000 mA, or at least 10000 mA.

Optionally in some examples, including in at least one preferred example, the processing circuitry is configured to further control the order in which the battery packs are disconnected from the common traction voltage bus, until all of the battery packs are disconnected, by opening the closed contactors according to the following: in response to that no closed contactor has a health level deviating from a mean health level of all contactors with more than the first predetermined value, and in response to that no closed contactor has a measured current deviating from a mean measured current of all contactors with more than a second predetermined value, opening any one of the closed contactors. A technical benefit may include an improved operation of the order in which the closed contactors are to be opened with regards to e.g. reducing the risk of single contactor failure. For example, the opening of the next closed contactor in time may be alternated in response to that no closed contactor has a health level deviating from a mean health level of all contactors with more than the first predetermined value, and that no closed contactor has a measured current deviating from a mean measured current of all contactors with more than a second predetermined value. The alternating opening may be performed according to a "round robin" process.

Optionally in some examples, including in at least one preferred example, the processing circuitry is configured to control the order in which the battery packs are disconnected from the common traction voltage bus, until all of the battery packs are disconnected, by opening the closed contactors according to the following: open the closed contactor having the lowest measured current in response to that no closed contactor has a health level deviating from a mean health level of all contactors with more than a first predetermined value; and open the closed contactor having the lowest health level in response to that the health level of such closed contactor deviates from the mean health level of all contactors with a value of more than the first predetermined value, and in response to that no closed contactor has a measured current deviating from a mean measured current of all contactors with more than a second predetermined value; and in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, open the first closed contactor or the second closed contactor; and in response to that no closed contactor has a health level deviating from a mean health level of all contactors with more than the first predetermined value, and in response to that no closed contactor has a measured current deviating from a mean measured current of all contactors with more than a second predetermined value, opening any one of the closed contactors.

Optionally in some examples, including in at least one preferred example, by stating that no closed contactor has a health level deviating from a mean health level of all contactors with more than the first predetermined value, the health levels for the closed contactors are approximately the same, or deemed to have corresponding values. Optionally in some examples, including in at least one preferred example, by stating that a closed contactor has a health level deviating from a mean health level of all contactors with more than the first predetermined value, the health levels for the closed contactors are not the same, or deemed not to have corresponding values.

Optionally in some examples, including in at least one preferred example, by stating that no closed contactor has a measured current deviating from the mean measured current of with more than the second predetermined value, the measured currents for the closed contactors are approximately the same, or deemed to have corresponding values. Optionally in some examples, including in at least one preferred example, by stating that a closed contactor has a measured current deviating from the mean measured current of with more than the second predetermined value, the measured currents for the closed contactors are not the same, or deemed not to have corresponding values.

According to a second aspect of the disclosure, a vehicle comprising the computer system of the first aspect of the disclosure is provided. The second aspect of the disclosure may seek to solve the same problem as described for the first aspect of the disclosure. Thus, effects and features of the second aspect of the disclosure are largely analogous to those described above in connection with the first aspect of the disclosure. The vehicle may e.g. comprise an energy storage system comprising a plurality of parallelly arranged battery packs as previously described.

Optionally in some examples, including in at least one preferred example, the vehicle further comprises an energy storage system comprising at least two parallelly arranged battery packs and a switching arrangement including a plurality of contactors, each contactor being configured to connect and disconnect an associated battery pack of the energy storage system to and from a common traction voltage bus by closing and opening, respectively.

According to a third aspect of the disclosure, a computer-implemented method is provided. The method comprises: determining, by a processing circuitry of a computer system, measured current over each one of a plurality of contactors of a switching arrangement of an energy storage system of a vehicle, the energy storage system comprising at least two parallelly arranged battery packs and each contactor is configured to connect and disconnect an associated battery pack of the energy storage system to and from a common traction voltage bus by closing and opening, respectively; determining, by the processing circuitry, a health level of each contactor; controlling, by the processing circuitry, the order in which the battery packs are disconnected from the common traction voltage bus, until all of the battery packs are disconnected, by opening closed contactors according to the following: opening the contactor associated with the lowest measured current in response to that no closed contactor has a health level deviating from a mean health level of all contactors with more than a first predetermined value; and opening the closed contactor having the lowest health level in response to that the health level of such closed contactor deviates from the mean health level of all contactors with a value of more than the first predetermined value, and in response to that no closed contactor has a measured current deviating from a mean measured current of all contactors with more than a second predetermined value.

The third aspect of the disclosure may seek to solve the same problem as described for the first aspect of the disclosure. Thus, effects and features of the third aspect of the disclosure are largely analogous to those described above in connection with the first aspect of the disclosure, and is not repeated here again. The processing circuitry is e.g. that of the first aspect of the disclosure.

Optionally in some examples, including in at least one preferred example, the method further comprises: determining, by the processing circuitry, the health level of each contactor as the general health level of the contactor.

Optionally in some examples, including in at least one preferred example, the method further comprises: determining, by the processing circuitry, the health level of each contactor by a scale of 0 % to 100 %.

Optionally in some examples, including in at least one preferred example, the method further comprises: controlling the order in which the battery packs are disconnected from the common traction voltage bus, until all of the battery packs are disconnected, by opening the closed contactors according to the following: in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, opening, by the processing circuitry, the first closed contactor or the second closed contactor.

Optionally in some examples, including in at least one preferred example, the method further comprises: opening, by the processing circuitry, the first closed contactor prior the second closed contactor in response to that the health level of the first closed contactor deviates from the mean health level of all contactors with a percentage rate higher than the deviation of the measured current of the second closed contactor from the mean measured current of all contactors.

Optionally in some examples, including in at least one preferred example, the method further comprises: opening, by the processing circuitry, the second closed contactor prior the first closed contactor in response to that the measured current of the second closed contactor deviates from the mean measured current of all contactors with a percentage rate higher than the deviation of the health level of the first closed contactor from the mean health level of all contactors.

Optionally in some examples, including in at least one preferred example, the method further comprises: repeating, by the processing circuitry, determining the measured current over each one of a plurality of contactors prior to each opening of a closed contactor.

Optionally in some examples, including in at least one preferred example, the method comprises performing any of the actions which the processing circuitry is configured to perform in the first aspect of the disclosure. Thus, the method may correspond to the configuration of the processing circuitry of the first aspect of the disclosure, which examples are not repeated here again.

According to a fourth aspect of the disclosure, a computer program product comprising program code for performing, when executed by the processing circuitry, the method of the third aspect of the disclosure is provided. The processing circuitry is e.g. that of the first aspect of the disclosure.

According to a fifth aspect of the disclosure, non-transitory computer-readable storage medium comprising instructions, which when executed by the processing circuitry, cause the processing circuitry to perform the method of the third aspect of the disclosure is provided. The processing circuitry is e.g. that of the first aspect of the disclosure.

The fourth to fifth aspects of the disclosure may seek to solve the same problem as described for the first aspect of the disclosure. Thus, effects and features of the fourth to fifth aspects of the disclosure are largely analogous to those described above in connection with the first aspect of the disclosure.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary, partly schematic, side view of an electric vehicle comprising an energy storage system having a plurality of parallelly arranged battery packs, and a control unit according to one example.
**FIG. 2** is a schematic view of a switching arrangement for an energy storage system of a vehicle, the energy storage system having a plurality of parallelly arranged battery packs and a control unit according to one example.
**FIG. 3** is a flowchart illustrating the actions or steps of a method according to one example.
**FIG. 4** is a schematic diagram of an exemplary computer system for implementing examples disclosed herein, according to one example.

### DETAILED DESCRIPTION

The detailed description set forth below provides information and examples of the disclosed technology with sufficient detail to enable those skilled in the art to practice the disclosure.

The disclosed technology may solve the problem relating to decreased life-length of the contactors, and/or single contactor failure, of an energy storage system. The contactors are configured to connect and disconnect battery packs of the energy storage system to and from a common traction voltage bus by closing and opening, respectively. The disclosed technology solves the problem by, inter alia, determining measured current and a health level of each contactor. The contactors may be referring to the closed contactors of the switching arrangement. The measured current and the health level of the contactors are used as input to determine, by the processing circuitry, the order in which the battery packs are disconnected from the common traction voltage bus, until all of the battery packs are disconnected, by opening the closed contactors. That is, in response to the measured current and the health level of the contactors, the processing circuitry determines which of the closed contactors that is to open next, until all of the battery packs are disconnected from the common traction voltage bus. Thus, the order in which the contactors are opened may be controlled in response to the health level and the measured current of the contactors, resulting in an improved operation including which of the different closed contactors that is to be opened next. As a contactor opening at a relatively high (or higher) current imposes a larger change in the health level compared to a contactor opening at a relatively low (or lower) current (i.e. the contactor is worn more at a contactor opening at the relatively high current), controlling the order in which the contactors are opened in response to the measured current and health level, an improved operation of the contactors and/or maintenance of contactor, and/or determination of contactor exchange, may be achieved.

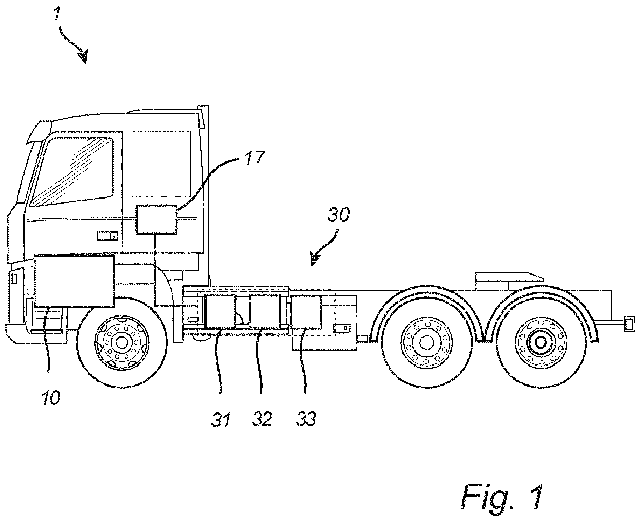

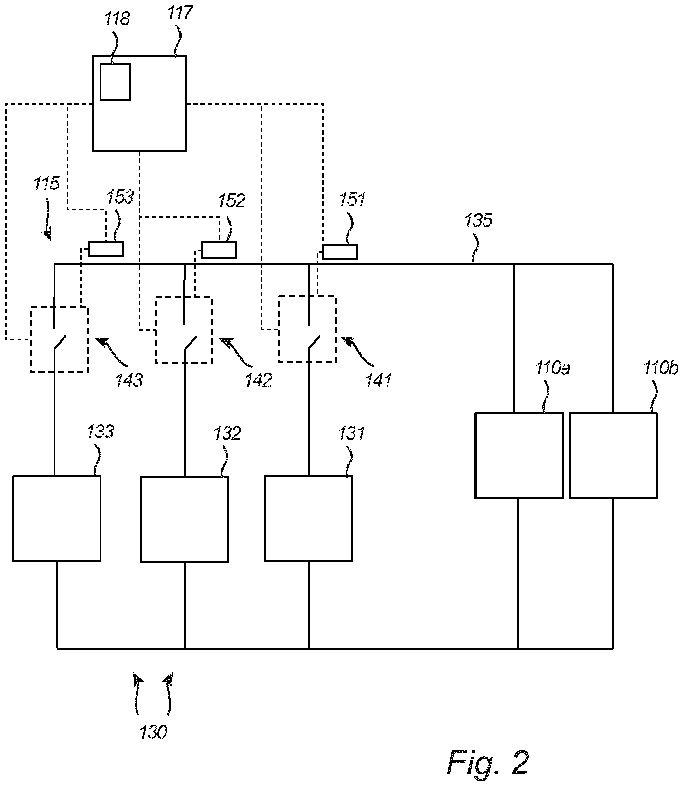

**FIG. 1** shows a vehicle 1 in the form of an exemplary heavy duty truck. The vehicle 1 is an electric vehicle, such as a full electric vehicle or a hybrid, comprising at least one electric machine 10 (as an electric traction machine) powered by an energy storage system 30, wherein in the example of Fig. 1, the energy storage system 30 comprises three parallelly connected battery packs 31, 32, 33. The battery packs 31, 32, 33 are configured to power at least one load, such as the electric machine 10. The vehicle 1 further comprises associated contactor for each battery pack 31, 32, 33 (exemplified in Fig. 2), the contactors being configured to connect and disconnect the battery packs 31, 32, 33 by closing and opening, respectively. The contactors may be comprised in a switching arrangement. Moreover, the vehicle 1 comprises a control unit 17 (comprising, or being comprised in, a processing circuitry) arranged and configured for controlling at least parts of the operation of the energy storage system 30, such as the opening and closing of the contactors. The vehicle 1 typically further comprises other parts of the powertrain such as transmission, drive shafts and wheels (not shown in detail). The electric machine 10 may be operated as an electric motor consuming electricity provided by the battery packs 31, 32, 33, e.g. to provide propulsion power, and may be operated as a generator to generate electricity to charge the battery packs 31, 32, 33.

**FIG. 2** is a schematic view of a switching arrangement 115 and an energy storage system 130 having a plurality of parallelly connected battery packs 131, 132, 133, and a control unit 117 including, or included in, processing circuitry. The example shown in Fig. 2 may be implemented in the vehicle 1 of Fig. 1. The plurality of battery packs 131, 132, 133 is arranged in parallel for connection to a common traction voltage bus 135 and powering of a plurality of loads 110a, 110b (e.g. one of the loads 110b being an electric machine, e.g. as electric machine 10 of Fig. 1). The switching arrangement 115 is configured to connect and disconnect the battery packs 131, 132, 133 to and from the common traction voltage bus 135. The common traction voltage bus 135 may in some examples be comprised in a junction box.

Each one of the battery packs 131, 132, 133 typically comprises a plurality of series-connected battery cells. The battery cells may be clustered into battery modules, wherein each battery pack 131, 132, 133 comprises a plurality of series-connected battery modules. The energy storage system 130 may be referred to as a multi-battery pack system.

In more detail, the energy storage system 130 comprises a first battery pack 131, a second battery pack 132 and a third battery pack 133, but it should be noted that any number of battery packs equal to, or higher than, two may be included in the energy storage system 130. The switching arrangement 115 comprises an associated contactor 141, 142, 143 for each battery pack 131, 132, 133. Thus, the switching arrangement 115 comprises a first contactor 141 configured to connect and disconnect the first battery pack 131 to and from to the common traction voltage bus 135 by closing and opening, respectively, and comprises a second contactor 142 configured to connect and disconnect the second battery pack 132 to and from the common traction voltage bus 135 by closing and opening, respectively, and comprising a third contactor 143 configured to connect and disconnect the third battery pack 133 to and from the common traction voltage bus 135 by closing and opening, respectively. Thus, an associated contactor, here being the first, second and third contactors 141, 142, 143, is provided for each battery pack, here being the corresponding first, second and third battery packs 131, 132, 133. The plurality of loads 110a, 110b may be powered by all, some, or any one, of the first, second and third battery packs 131, 132, 133 by closing the corresponding first, second and third contactors 141, 142, 143, i.e. by connecting the first, second and third battery packs 131, 132, 133 to the common traction voltage bus 135.

Any one of, some, or all of, the first, second and third battery packs 131, 132, 133 may be disconnected from the common traction power bus 135 by opening the corresponding the first, second and third contactors 141, 142, 143. The control unit 117 is configured to control at least part of the operation of the switching arrangement 115, and thus the opening and closing of the first, second and third contactors 141, 142, 143. The switching arrangement 115 is, via the control unit 117, configured to disconnect the first, second and third battery packs 131, 132, 133 from the common traction voltage bus 135 by means of the first, second and third contactors 141, 142, 143, respectively. The switching arrangement 115 may comprise additional contactors (e.g. pre-charge contactors, secondary contactors) for one or more of the battery packs 131, 132, 133.

In a first state being a fully connected state, each one of the first, second and third contactors 141, 142, 143 are closed and each one of the first, second and third battery packs 131, 132, 133 are connected to the common traction voltage bus 135 for powering the plurality of loads 110a, 110b. In a second state, being a disconnection state, one, two, or all three of the first, second and third contactors 141, 142, 143 are opened to disconnect the corresponding first, second and/or third battery pack 131, 132, 133 from the common traction voltage bus 135.

The energy storage system 130 of Fig. 2 comprises a plurality of sensors configured to measure at least current for each one of the contactors 141, 142, 143. In more detail, a first sensor 151 is configured to measure the current of the first contactor 141, a second sensor 152 is configured to measure the current of the second contactor 142, and a third current 153 is configured to measure the current of the third contactor 143. Each one of the first, second and third sensors 151, 152, 153 is schematically shown in Fig. 2 and may be a corresponding current sensor. Such current sensors are typically arranged to measure the current over the corresponding contactors 141, 142, 143. However, it should be mentioned that the sensors may be voltage sensors, or another type of sensor, which determine the current based on measurements of the voltage over the contactors 141, 142, 143 using applicable empirical laws, such as e.g. Ohm's law. Thus, as such determined current is based on measurements (voltage, resistance, etcetera), it may still be referred to as determined measured current. The control unit 117 is configured to receive the measurement data, or measured current, from the sensors 131, 132, 133.

Upon disconnection of a battery pack 131, 132, 133, and opening of the corresponding contactor 141, 142, 143, the contactor 141, 142, 143 is subject to contactor wear upon opening. A contactor opening at a relatively high (or higher) current imposes a larger wear compared to a contactor opening at a relatively low (or lower) current.

Each one of the contactors 141, 142, 143 may be characterized by a corresponding health level, or health condition. The health level of each contactor 141, 142, 143 may be defined by a scale of 0 % to at least 100 %. For example, 0 % health level may correspond to an indefectible contactor. An indefectible contactor may also be referred to as an unworn, fresh, new or unused contactor. Correspondingly, 100 % health level may correspond to a contactor which is deemed to be exchanged, or subject to maintenance. A contactor having a health level of 100 %, or a contactor deemed to be exchanged, may thus be functional but considered to have reached a predetermined threshold for which the operation of the contactor no longer is reliable. Thus, the contactor may still be operated at a health level of 100 %, and the health level increase may still be accounted for, e.g. to an overdue health level of 20 % (i.e. a corresponding health level of 120 %). The health level of the contactors 141, 142, 143 may be determined by its corresponding total operation time, its corresponding total number of contactor openings or a combination thereof. For example, a health level of 0 % may correspond to a total operation time of 0 h, or a total number of contactor openings of 0. Correspondingly, a health level of 100 % may correspond to a total operation time, or total number of contactor openings, for which the contactor is deemed to be exchanged, e.g. an operation time over a predetermined operation time threshold, or a number of contactor openings over a predetermined contactor opening threshold. The health level of each contactor 141, 142, 143 may alternatively be determined by the total number of openings as a function of the current at which the opening occurred (i.e. the current just prior to the contactor opening). For example, a contactor opening at a relatively high current may impose a larger change in the health level (e.g. 0.1 percentage points change in the health level) as compared to a contactor opening at a relatively low current (e.g. 0.01 percentage points change in the health level). Thus, the health level of the contactors 141, 142, 143 can be accounted for in an efficient manner, and changed over time in an accurate way.

The control unit 117 may be configured to determine measured current over each one the contactors 141, 142, 143, or at least the closed contactors, using e.g. the first, second and third sensors 151, 152, 153. Moreover, the control unit 117 may be configured to determine the health level of each contactor 141, 142, 143, or at least each closed contactor, e.g. using the previously described definition of the contactor health level. Moreover, the control unit 117 is typically configured to keep track of the health level of the contactors 141, 142, 143 over time, and adapt the health level accordingly. As seen in Fig. 2, the switching arrangement 115 may further comprise a memory 118 for storing such health level data. Correspondingly, the control unit 117 may be configured to repeat determining the measured current over each contactor 141, 142, 143 prior to each opening of a contactor 141, 142, 143. The determined health level of each closed contactor is typically corresponding to the general health level of the contactor. A closed contactor is to be understood as a contactor currently providing an electrical connection, i.e. an electricity pathway, from the associated battery pack to the common traction voltage bus 135.

The control unit 117 may be configured to determine the mean health level of all contactors 141, 142, 143, or at least of all closed contactors. The mean health level may e.g. be determined by the ratio of the sum of the health level for all closed contactors, and the number of closed contactors for which the health level is determined. Correspondingly, the control unit 117 may be configured to determine the mean measured current of all contactors 141, 142, 143, or at least of all closed contactors. The mean measured current may e.g. be determined by the ratio of the sum of the measured current for all closed contactors, and the number of closed contactors for which the current is measured.

By the measured current and the determined health level of the contactors 141, 142, 143, the control unit 117 may control the order in which the closed contactors 141, 142, 143 are opened. That is, the control unit 117 may be configured to control the order in which the battery packs 131, 132, 133 are disconnected from the common traction voltage bus 135, until all of the battery packs are disconnected, by opening the closed contactors in response to the measured current and the health level of the contactors 141, 142, 143.

In more detail, the switching arrangement 115 is, via the control unit 117, configured to disconnect the first, second and third battery packs 131, 132, 133 from the common traction voltage bus 135 by means of the first, second and third contactors 141, 142, 143, respectively, such that the first, second and third battery packs 131, 132, 133 are disconnected in an order in which one contactor, e.g. the first contactor 141, is opened first, one contactor, e.g. the second contactor 142, is opened second, and one contactor, e.g. the third contactor 143, is opened last so that all battery packs 131, 132, 133 are disconnected (i.e. so that no battery pack is longer connected to the common traction voltage bus 135). Assuming a fully connected state, the control unit 117 may be configured to control the order in which the battery packs 131, 132, 133 are disconnected from the common traction voltage bus 135, until all of the battery packs 131, 132, 133 are disconnected, by opening the closed contactors 141, 142, 143 according to the following: open the closed contactor having the lowest measured current in response to that no closed contactor has a health level deviating from a mean health level of all contactors 141, 142, 143 with more than a first predetermined value, and open the closed contactor having the lowest health level in response to that the health level of such closed contactor deviates from the mean health level of all contactors 141, 142, 143 with a value of more than the first predetermined value, and in response to that no closed contactor has a measured current deviating from a mean measured current of all contactors 141, 142, 143 with more than a second predetermined value. Thus, the order in which the contactors 141, 142, 143 are opened may be controlled in response to the health level and the measured current of the contactors 141, 142, 143, resulting in an improved operation of which closed contactors are to be opened next. Hereby, the risk of a single contactor failure, or at least premature single contactor failure, is reduced. For each contactor opening, the control unit 117 may again determine the health level and measured current for each one of the contactors 141, 142, 143 and then repeat the above control of the opening of the contactors 141, 142, 143. Hereby, the health level for each one of the contactors 141, 142, 143 can be determined and logged. Thus, the energy storage system may be brought from the fully connected state to a disconnected state in which each one of the first, second and third contactors 141, 142, 143 are opened in such a way that each one of the first, second and third battery packs 131, 132, 133 are being disconnected from the common traction voltage bus 135, terminating powering of the loads 110a, 110b (e.g. in response to a shut-off signal of the loads 1 10a, 1 10b). However, the shut-off of the loads 1 10a, 110b may be performed also in the fully connected state, such that the loads 1 10a, 110b do not request or draw any power from the battery packs 131, 132, 133, whereafter the connectors 141, 142, 143 are opened by the controlled procedure as presented above.

Moreover, the control unit 117 may be further configured to control the order in which the battery packs 131, 132, 133 are disconnected from the common traction voltage bus 135, until all of the battery packs 131, 132, 133 are disconnected, by opening the closed contactors 141, 142, 143 according to the following: in response to that a first closed contactor, e.g. the first contactor 141, has the lowest health level and that the health level of the first closed contactor 141 deviates from the mean health level of all contactors 141, 142, 143 with a value of more than the first predetermined value, and in response to that a second closed contactor, e.g. the second contactor 142, has the lowest measured current and that the measured current of the second closed contactor deviates from the mean measured current of all contactors 141, 142, 143 with more than the second predetermined value, open the first closed contactor 141 or the second closed contactor 142.

In deciding whether the first contactor 141 or the second contactor 142 is to be opened, a weighting between the health level and the measured current may be implemented by the control unit. For example, the control unit 117 may be configured to open the first closed contactor 141 prior the second closed contactor 142 in response to that the health level of the first closed contactor 141 deviates from the mean health level of all contactors 141, 142, 143 with a percentage rate higher than the deviation of the measured current of the second closed contactor 142 from the mean measured current of all contactors 141, 142, 143. Alternatively, or additionally, the control unit 117 is configured to open the second closed contactor 142 prior the first closed contactor 141 in response to that the measured current of the second closed contactor 142 deviates from the mean measured current of all contactors 141, 142, 143 with a percentage rate higher than the deviation of the health level of the first closed contactor 141 from the mean health level of all contactors 141, 142, 143.

Moreover, the control unit 117 may be further configured to control the order in which the battery packs 131, 132, 133 are disconnected from the common traction voltage bus 135, until all of the battery packs 131, 132, 133 are disconnected, by opening the closed contactors 141, 142, 143 according to the following: in response to that no closed contactor has a health level deviating from a mean health level of all contactors 141, 142, 143 with more than the first predetermined value, and in response to that no closed contactor has a measured current deviating from a mean measured current of all contactors 141, 142, 143 with more than the second predetermined value, opening any one of the closed contactors. For example, the opening of the next closed contactor in time may be alternated in response to that no closed contactor has a health level deviating from a mean health level of all contactors 141, 142, 143 with more than the first predetermined value, and that no closed contactor has a measured current deviating from a mean measured current of all contactors 141, 142, 143 with more than a second predetermined value. The alternating opening may be performed according to a "round robin" process.

A summarizing example of the order in which the battery packs 131, 132, 133 are disconnected from the common traction voltage bus 135, until all of the battery packs 131, 132, 133 are disconnected, is summarized in Table 1. Thus, depending on the outcome of the measured current and the health level of the contactors, Table 1 indicates which contactor that is to be opened next.

**Table 1**

| | Health level for the closed contactors is approximately the same: No closed contactor has a health level deviating from the mean health level of all contactors with more than the first predetermined value | Health level for the closed contactors is not the same: A closed contactor has a health level deviating from the mean health level of all contactors with more than the first predetermined value |
|---|---|---|
| Measured current for the closed contactors is approximately the same: No closed contactor has a measured current deviating from the mean measured current of with more than the second predetermined value | *Open any closed contactor (typically alternating opening of the next contactor, e.g according to a round robin process).* | *Open the closed contactor having the lowest health level.* |
| Measured current for the closed contactors is not the same: A closed contactor has a measured current deviating from the mean measured current of with more than the second predetermined value | *Open the closed contactor having the lowest measured current.* | *Open the closed contactor having the lowest health level or the closed contactor having the lowest measured current depending on a weighting between the health level and the measured current.* |

Moreover, the control unit 117 may be further configured to: subsequent to controlling the order in which the closed contactors 141, 142, 143 are opened, connect at least two of the battery packs 131, 132, 133 to the common traction voltage bus 135 by closing the associated contactors 141, 142. 143, and thereafter: alternately connect and disconnect the battery packs 131, 132, 133 from and to the common traction voltage bus 135, wherein said controlling of the order in which the closed contactors 141, 142, 143 are opened, or opened next, is performed for each disconnection.

In addition to controlling the order in which the contactors 141, 142, 143 are opened in response to the measured current and health level of the contactors, as described above, the control unit 117 may predict maintenance of contactors 141, 142, 143, or contactor exchange, in response to the health level. For example, if the health level for one contactor reaches a predetermined threshold, e.g. 100 % of the health level, the control unit 117 may indicate (e.g. to the driver of the vehicle) that such contactor is to be serviced, or exchanged. Hereby, the risk of having a single contactor leading to contactor failure, or premature contactor failure, may be avoided, or at least reduced. In case one contactor is exchanged, a new contactor, e.g. with a 0 % health level, may replace the old contactor.

It should be mentioned that the switching arrangement 115 of Fig. 2 may further comprise a first pre-charge contactor arranged in parallel to the first contactor 141, wherein the first pre-charge contactor is arranged in series with a first pre-charge resistor, and comprise a second pre-charge contactor arranged in parallel to the second contactor 142, wherein the second pre-charge contactor is arranged in series with a second pre-charge resistor, and comprise a third pre-charge contactor arranged in parallel to the third contactor 143, wherein the third pre-charge contactor is arranged in series with a third pre-charge resistor. Moreover, the first battery pack 131 may be connected in series with a first secondary contactor arranged on the opposite side of the first battery pack 131 as compared to the first contactor 141 (e.g. the first contactor 141 being arranged at a positive terminal side of the first battery pack 131, and the first secondary contactor being arrange at a negative terminal side of the first battery pack 131). Correspondingly, the second battery pack 132 may be connected in series with a second secondary contactor arranged on the opposite side of the second battery pack 132 as compared to the second contactor 142, and the third battery pack 133 may be connected in series with a third secondary contactor arranged on the opposite side of the third battery pack 133 as compared to the third contactor 143.

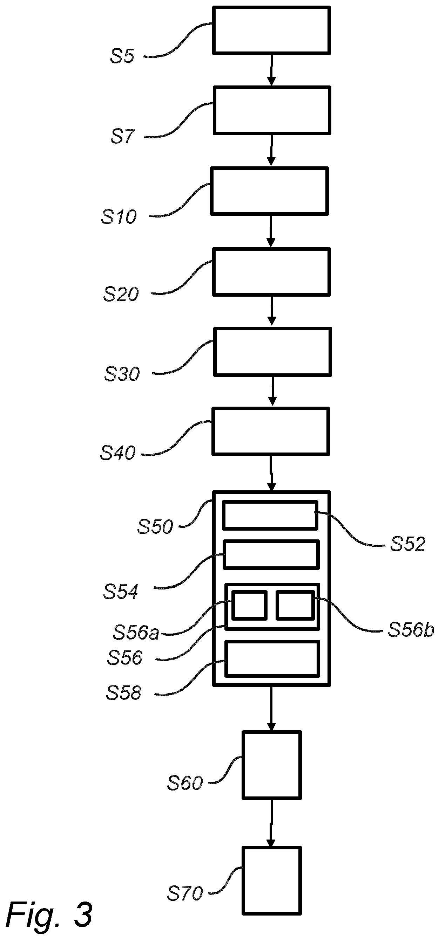

**FIG. 3** is a flow chart of a computer-implemented method for controlling a switching arrangement of an energy storage system of a vehicle, such as the switching arrangement 115 and the energy storage system 130 of Fig. 2.

In a first action or step, S10, measured current over each one of a plurality of contactors of the switching arrangement is determined by a processing circuitry of a computer system. The energy storage system comprises at least two parallelly arranged battery packs and each contactor is configured to connect and disconnect an associated battery pack of the energy storage system to and from a common traction voltage bus by closing and opening, respectively. The plurality of contactors may be a plurality of closed contactors of the switching arrangement. The first action or step S10 may comprise receiving, by the processor circuitry, measurement data from a plurality of sensors of the energy storage system, wherein the measurement data comprises measured current over each one of a plurality of contactors.

In a second, optional action or step S20, the mean measured current of all contactors is determined by the processor circuitry. The mean measured current may e.g. be determined by the ratio of the sum of the measured current for all closed contactors, and the number of closed contactors for which the current is measured.

In a third action or step S30, a health level of each contactor is determined by the processor circuitry. The health level for a specific contactor may e.g. be the general health level of such contactor. For example, the health level of each contactor may be determined by the processor circuitry by a scale of 0 % to 100 %.

In a fourth, optional action or step S40, the mean health level of all contactors is determined by the processor circuitry. The mean health level may e.g. be determined by the ratio of the sum of the health level for all closed contactors, and the number of closed contactors.

In a fifth action or step S50, the order in which the battery packs are disconnected from the common traction voltage bus, until all of the battery packs are disconnected, is controlled by opening closed contactors according to the following: In a first sub-action or sub-step S52, the contactor associated with the lowest measured current is opened by the processing circuitry in response to that no closed contactor has a health level deviating from the mean health level of all contactors with more than a first predetermined value; in a second sub-action or sub-step S54, the closed contactor having the lowest health level is opened by the processing circuitry in response to that the health level of such closed contactor deviates from the mean health level of all contactors with a value of more than the first predetermined value, and in response to that no closed contactor has a measured current deviating from the mean measured current of all contactors with more than a second predetermined value. That is, in response to the measured current and the health level of the contactors, the closed contactors are opened in an order, by the processing circuitry, until all of the battery packs are disconnected from the common traction voltage bus. Thus, the order in which the contactors are opened may be controlled in response to the health level and the measured current of the contactors, resulting in an improved operation including which of the closed contactors that is to be opened next. Typically, the first step S10, and possibly the third step S30 as well as the second and/or fourth steps S20, S40, is repeated prior to each opening of a closed contactor.

In an optional sub-action or sub-step S56 to S50, in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, the first closed contactor or the second closed contactor is opened by the processing circuitry. In deciding whether the first contactor or the second contactor is to be opened, a weighting between the health level and the measured current may be implemented by the processing circuitry. For example, in sub-action or sub-step S56a, the first closed contactor is opened by the processing circuitry prior the second closed contactor in response to that the health level of the first closed contactor deviates from the mean health level of all contactors with a percentage rate higher than the deviation of the measured current of the second closed contactor from the mean measured current of all contactors. Alternatively, in sub-action or sub-step S56b, the second closed contactor is opened by the processor circuitry prior the first closed contactor in response to that the measured current of the second closed contactor deviates from the mean measured current of all contactors with a percentage rate higher than the deviation of the health level of the first closed contactor from the mean health level of all contactors.

In an optional sub-action or sub-step S58 to S60, in response to that no closed contactor has a health level deviating from a mean health level of all contactors with more than the first predetermined value, and in response to that no closed contactor has a measured current deviating from a mean measured current of all contactors with more than a second predetermined value, any one of the closed contactors are opened. For example, the opening of the next closed contactor in time may be alternated according to a "round robin" process.

The method may comprise a sixth action or step S60 of closing, by the processing circuitry, the contactors to connect the battery packs to the common traction voltage bus. Moreover, as previously described, the battery packs may be alternately connected and disconnected from and to the common traction voltage bus, wherein the actions or steps of disconnection include controlling the order in which the contactors are opened as described above. Thus, the controlled order of disconnection of the battery packs by the switching arrangement may be applied over time and during the operation of the energy storage system.

In an optional seventh action or step S70, maintenance of contactor, or contactor exchange, is predicted by the processing circuitry in response to the health level of the contactors. For example, the contactor maintenance information may be sent to a display, such as e.g. a vehicle monitor. Hereby, the driver of the vehicle may utilize the contactor maintenance information and decide upon service of the switching arrangement.

In a first optional pre-action or pre-step S5 to the first action or step S10, a plurality of parallelly arranged battery packs connected to the common traction voltage bus of the energy storage system is identified by the processing circuitry. In a second optional pre-action or step S7 to the first action or step S10, associated closed contactors to the plurality of parallelly arranged battery packs are identified by the processing circuitry. Such identified closed contactors may then be subject to the previously described actions or steps S10, optional S20, S30, optional S40, and S50. Thus, the fifth action or step S50 may be performed for all of the identified closed contactors.

It should be noted that not all battery packs of the energy storage system need to be connected each time a load connected to the common traction voltage bus is to be powered by the energy storage system. For example, in case the load is only requiring two out of three battery packs in order to be powered, the third battery pack, and thus the associated contactor to the third battery pack, may rest during such case. During disconnection of the connected battery packs, the controlled sequence of disconnection by the switching arrangement will be applied to the battery packs being connected to the common traction voltage bus for powering the load, i.e. in this case the first and second battery packs.

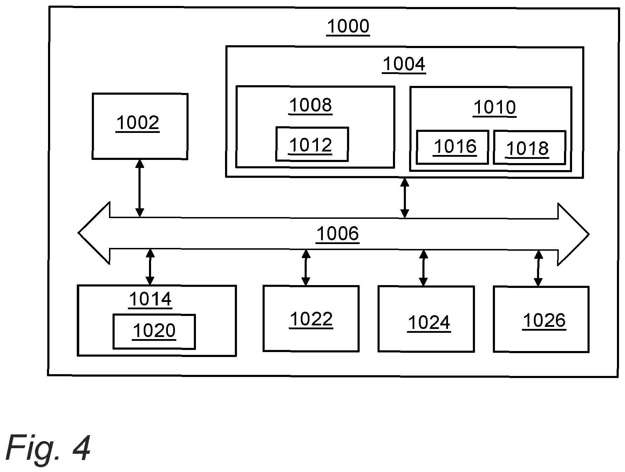

The control unit 17 of Fig. 1, or the control unit 117 of Fig. 2, may be configured to perform the method as described with reference to Fig. 3. Thus, and with reference to Fig. 1, the processing circuitry may comprise, or be comprised in, the control unit 17 of the vehicle 1, or with reference to Fig. 2, the processing circuitry may comprise, or be comprised in, the control unit 117. The method as described with reference to Fig. 3 may thus be implemented in a computer program product comprising program code for performing, when executed by the processing circuitry, the method described with reference to Fig. 3. Alternatively the method as described with reference to Fig. 3 may be implemented in a non-transitory computer-readable storage medium comprising instructions, which when executed by the processing circuitry, cause the processing circuitry to perform the method as described with reference to Fig. 3. Thus, the control unit 17 may comprise instructions to cause the energy storage system 30 to be operated according to at least some of the actions or steps described with reference to Fig. 3. Moreover, the control unit 117 of Fig. 2 may comprise instructions to cause the switching arrangement 115 to be operated according to at least some of the actions or steps described with reference to Fig. 3. The control unit 17 of the vehicle 1 of Fig. 1, or the control unit 117 of the switching arrangement 115 of Fig. 2, may constitute, or be comprised in, a control system comprising one or more control units configured to perform the method as described with reference to Fig. 3. Such control system 1000 is now described with reference to Fig. 4.

**FIG. 4** is a schematic diagram of a computer system 1000 for implementing examples disclosed herein, e.g. the method as described with reference to Fig. 3. The computer system 1000 is adapted to execute instructions from a computer-readable medium to perform these and/or any of the functions or processing described herein. The computer system 1000 may be connected (e.g., networked) to other machines in a LAN, an intranet, an extranet, or the Internet. While only a single device is illustrated, the computer system 1000 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 1000 may comprise at least one computing device or electronic device capable of including firmware, hardware, and/or executing software instructions to implement the functionality described herein. The computer system 1000 may include a processing circuitry 1002 (e.g., processing circuitry including one or more processor devices or control units), a memory 1004, and a system bus 1006. The computer system 1000 may include at least one computing device having the processing circuitry 1002. The system bus 1006 provides an interface for system components including, but not limited to, the memory 1004 and the processing circuitry 1002. The processing circuitry 1002 may include any number of hardware components for conducting data or signal processing or for executing computer code stored in memory 1004. The processing circuitry 1002 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 1002 may further include computer executable code that controls operation of the programmable device.

The system bus 1006 may be any of several types of bus structures that may further interconnect to a memory bus (with or without a memory controller), a peripheral bus, and/or a local bus using any of a variety of bus architectures. The memory 1004 may be one or more devices for storing data and/or computer code for completing or facilitating methods described herein. The memory 1004 may include database components, object code components, script components, or other types of information structure for supporting the various activities herein. Any distributed or local memory device may be utilized with the systems and methods of this description. The memory 1004 may be communicably connected to the processing circuitry 1002 (e.g., via a circuit or any other wired, wireless, or network connection) and may include computer code for executing one or more processes described herein. The memory 1004 may include non-volatile memory 1008 (e.g., read-only memory (ROM), erasable programmable read-only memory (EPROM), electrically erasable programmable read-only memory (EEPROM), etc.), and volatile memory 1010 (e.g., random-access memory (RAM)), or any other medium which can be used to carry or store desired program code in the form of machine-executable instructions or data structures and which can be accessed by a computer or other machine with a processing circuitry 1002. A basic input/output system (BIOS) 1012 may be stored in the non-volatile memory 1008 and can include the basic routines that help to transfer information between elements within the computer system 1000.

The computer system 1000 may further include or be coupled to a non-transitory computer-readable storage medium such as the storage device 1014, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 1014 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 1014 and/or in the volatile memory 1010, which may include an operating system 1016 and/or one or more program modules 1018. All or a portion of the examples disclosed herein may be implemented as a computer program 1020 stored on a transitory or non-transitory computer-usable or computer-readable storage medium (e.g., single medium or multiple media), such as the storage device 1014, which includes complex programming instructions (e.g., complex computer-readable program code) to cause the processing circuitry 1002 to carry out actions described herein. Thus, the computer-readable program code of the computer program 1020 can comprise software instructions for implementing the functionality of the examples described herein when executed by the processing circuitry 1002. In some examples, the storage device 1014 may be a computer program product (e.g., readable storage medium) storing the computer program 1020 thereon, where at least a portion of a computer program 1020 may be loadable (e.g., into a processor) for implementing the functionality of the examples described herein when executed by the processing circuitry 1002. The processing circuitry 1002may serve as a controller or control system for the computer system 1000 that is to implement the functionality described herein.

The computer system 1000 may include an input device interface 1022 configured to receive input and selections to be communicated to the computer system 1000 when executing instructions, such as from a keyboard, mouse, touch-sensitive surface, etc. Such input devices may be connected to the processing circuitry 1002 through the input device interface 1022 coupled to the system bus 1006 but can be connected through other interfaces, such as a parallel port, an Institute of Electrical and Electronic Engineers (IEEE) 1394 serial port, a Universal Serial Bus (USB) port, an IR interface, and the like. The computer system 1000 may include an output device interface 1024 configured to forward output, such as to a display, a video display unit (e.g., a liquid crystal display (LCD) or a cathode ray tube (CRT)). The computer system 1000 may include a communications interface 1026 suitable for communicating with a network as appropriate or desired.

The actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1. A computer system comprising processing circuitry configured to: determine measured current over each one of a plurality of contactors of a switching arrangement of an energy storage system of a vehicle, the energy storage system comprising at least two parallelly arranged battery packs and each contactor is configured to connect and disconnect an associated battery pack of the energy storage system to and from a common traction voltage bus by closing and opening, respectively; determine a health level of each contactor; control the order in which the battery packs are disconnected from the common traction voltage bus, until all of the battery packs are disconnected, by opening closed contactors according to the following: - open the closed contactor having the lowest measured current in response to that no closed contactor has a health level deviating from a mean health level of all contactors with more than a first predetermined value, and - open the closed contactor having the lowest health level in response to that the health level of such closed contactor deviates from the mean health level of all contactors with a value of more than the first predetermined value, and in response to that no closed contactor has a measured current deviating from a mean measured current of all contactors with more than a second predetermined value.

Example 2. The computer system of example 1, wherein the processing circuitry is configured to determine the health level of each contactor as the general health level of the contactor.

Example 3. The computer system of any of examples 1-2, wherein the processing circuitry is configured to determine the health level of each contactor by a scale of 0 % to 100 %.

Example 4. The computer system of any of examples 1-3, wherein the processing circuitry is configured to further control the order in which the battery packs are disconnected from the common traction voltage bus, until all of the battery packs are disconnected, by opening the closed contactors according to the following: - in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, open the first closed contactor or the second closed contactor.

Example 5. The computer system of example 4, wherein the processing circuitry is configured to open the first closed contactor prior the second closed contactor in response to that the health level of the first closed contactor deviates from the mean health level of all contactors with a percentage rate higher than the deviation of the measured current of the second closed contactor from the mean measured current of all contactors.

Example 6. The computer system of any of examples 4-5, wherein the processing circuitry is configured to open the second closed contactor prior the first closed contactor in response to that the measured current of the second closed contactor deviates from the mean measured current of all contactors with a percentage rate higher than the deviation of the health level of the first closed contactor from the mean health level of all contactors.

Example 7. The computer system of any of examples 1-6, wherein the processing circuitry is further configured to: receive measurement data from a plurality of sensors of the energy storage system, wherein the measurement data comprises measured current over each one of a plurality of contactors.

Example 8. The computer system of any of examples 1-7, wherein the processing circuitry is further configured to repeat determining the measured current over each one of a plurality of contactors prior to each opening of a contactor.

Example 9. The computer system of any of examples 1-8, wherein the processing circuitry is further configured to: subsequent to controlling the order in which the closed contactors are opened, connect at least two of the battery packs to the common traction voltage bus by closing the associated contactors, and thereafter: alternately connect and disconnect the battery packs from and to the common traction voltage bus, wherein said controlling of the order in which the closed contactors are opened is performed for each disconnection.

Example 10. A vehicle comprising the computer system of any of examples 1-9.

Example 11. The vehicle of example 10, further comprising: an energy storage system comprising at least two parallelly arranged battery packs and a switching arrangement including a plurality of contactors, each contactor being configured to connect and disconnect an associated battery pack of the energy storage system to and from a common traction voltage bus by closing and opening, respectively.

Example 12. A computer-implemented method, comprising: determining, by a processing circuitry of a computer system, measured current over each one of a plurality of contactors of a switching arrangement of an energy storage system of a vehicle, the energy storage system comprising at least two parallelly arranged battery packs and each contactor is configured to connect and disconnect an associated battery pack of the energy storage system to and from a common traction voltage bus by closing and opening, respectively; determining, by the processing circuitry, a health level of each contactor; controlling, by the processing circuitry, the order in which the battery packs are disconnected from the common traction voltage bus, until all of the battery packs are disconnected, by opening closed contactors according to the following: - opening the contactor associated with the lowest measured current in response to that no closed contactor has a health level deviating from a mean health level of all contactors with more than a first predetermined value, and - opening the closed contactor having the lowest health level in response to that the health level of such closed contactor deviates from the mean health level of all contactors with a value of more than the first predetermined value, and in response to that no closed contactor has a measured current deviating from a mean measured current of all contactors with more than a second predetermined value.

Example 13. The method of example 12, further comprising: determining, by the processing circuitry, the health level of each contactor as the general health level of the contactor.

Example 14. The method of any of examples 12-13, further comprising: determining, by the processing circuitry, the health level of each contactor by a scale of 0 % to 100 %.

Example 15. The method of any of examples 12-14, further comprising: controlling the order in which the battery packs are disconnected from the common traction voltage bus, until all of the battery packs are disconnected, by opening the closed contactors according to the following: - in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, opening, by the processing circuitry, the first closed contactor or the second closed contactor.

Example 16. The method of example 15, further comprising: opening, by the processing circuitry, the first closed contactor prior the second closed contactor in response to that the health level of the first closed contactor deviates from the mean health level of all contactors with a percentage rate higher than the deviation of the measured current of the second closed contactor from the mean measured current of all contactors.

Example 17. The method of any of examples 15-16, further comprising: opening, by the processing circuitry, the second closed contactor prior the first closed contactor in response to that the measured current of the second closed contactor deviates from the mean measured current of all contactors with a percentage rate higher than the deviation of the health level of the first closed contactor from the mean health level of all contactors.

Examples 18. The method of any of examples 12-17, further comprising: repeating, by the processing circuitry, determining the measured current over each one of a plurality of contactors prior to each opening of a closed contactor.

Example 19. A computer program product comprising program code for performing, when executed by the processing circuitry, the method of any of examples 12-18.

Example 20. A non-transitory computer-readable storage medium comprising instructions, which when executed by the processing circuitry, cause the processing circuitry to perform the method of any of examples 12-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system comprising processing circuitry configured to:
- determine measured current over each one of a plurality of contactors of a switching arrangement of an energy storage system of a vehicle, the energy storage system comprising at least two parallelly arranged battery packs and each contactor is configured to connect and disconnect an associated battery pack of the energy storage system to and from a common traction voltage bus by closing and opening, respectively,
- determine a health level of each contactor,
- control the order in which the battery packs are disconnected from the common traction voltage bus, until all of the battery packs are disconnected, by opening closed contactors according to the following:
- open the closed contactor having the lowest measured current in response to that no closed contactor has a health level deviating from a mean health level of all contactors with more than a first predetermined value, and
- open the closed contactor having the lowest health level in response to that the health level of such closed contactor deviates from the mean health level of all contactors with a value of more than the first predetermined value, and in response to that no closed contactor has a measured current deviating from a mean measured current of all contactors with more than a second predetermined value.

2. The computer system of claim 1, wherein the processing circuitry is further configured to determine the health level of each contactor as the general health level of the contactor.

3. The computer system of any of claims 1-2, wherein the processing circuitry is further configured to determine the health level of each contactor by a scale of 0 % to 100 %.

4. The computer system of any of claims 1-3, wherein the processing circuitry is further configured to further control the order in which the battery packs are disconnected from the common traction voltage bus, until all of the battery packs are disconnected, by opening the closed contactors according to the following:
- in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, open the first closed contactor or the second closed contactor.

5. The computer system of claim 4, wherein the processing circuitry is further configured to open the first closed contactor prior the second closed contactor in response to that the health level of the first closed contactor deviates from the mean health level of all contactors with a percentage rate higher than the deviation of the measured current of the second closed contactor from the mean measured current of all contactors.

6. The computer system of any of claims 4-5, wherein the processing circuitry is further configured to open the second closed contactor prior the first closed contactor in response to that the measured current of the second closed contactor deviates from the mean measured current of all contactors with a percentage rate higher than the deviation of the health level of the first closed contactor from the mean health level of all contactors.

7. The computer system of any of claims 1-6, wherein the processing circuitry is further configured to: receive measurement data from a plurality of sensors of the energy storage system, wherein the measurement data comprises measured current over each one of a plurality of contactors.

8. The computer system of any of claims 1-7, wherein the processing circuitry is further configured to: subsequent to controlling the order in which the closed contactors are opened, connect at least two of the battery packs to the common traction voltage bus by closing the associated contactors, and thereafter:
alternately connect and disconnect the battery packs from and to the common traction voltage bus, wherein said controlling of the order in which the closed contactors are opened is performed for each disconnection.

9. A vehicle comprising the computer system of any of claims 1-8.

10. The vehicle of claim 9, further comprising: an energy storage system comprising at least two parallelly arranged battery packs and a switching arrangement including a plurality of contactors, each contactor being configured to connect and disconnect an associated battery pack of the energy storage system to and from a common traction voltage bus by closing and opening, respectively.

11. A computer-implemented method, comprising:
- determining, by a processing circuitry of a computer system, measured current over each one of a plurality of contactors of a switching arrangement of an energy storage system of a vehicle, the energy storage system comprising at least two parallelly arranged battery packs and each contactor is configured to connect and disconnect an associated battery pack of the energy storage system to and from a common traction voltage bus by closing and opening, respectively,
- determining, by the processing circuitry, a health level of each contactor,
- controlling, by the processing circuitry, the order in which the battery packs are disconnected from the common traction voltage bus, until all of the battery packs are disconnected, by opening closed contactors according to the following:
- opening the contactor associated with the lowest measured current in response to that no closed contactor has a health level deviating from a mean health level of all contactors with more than a first predetermined value, and
- opening the closed contactor having the lowest health level in response to that the health level of such closed contactor deviates from the mean health level of all contactors with a value of more than the first predetermined value, and in response to that no closed contactor has a measured current deviating from a mean measured current of all contactors with more than a second predetermined value.

12. The method of claim 11, further comprising: controlling the order in which the battery packs are disconnected from the common traction voltage bus, until all of the battery packs are disconnected, by opening the closed contactors according to the following:
- in response to that a first closed contactor has the lowest health level and that the health level of the first closed contactor deviates from the mean health level of all contactors with a value of more than the first predetermined value, and in response to that a second closed contactor has the lowest measured current and that the measured current of the second closed contactor deviates from the mean measured current of all contactors with more than the second predetermined value, opening, by the processing circuitry, the first closed contactor or the second closed contactor.

13. The method of claim 12, further comprising: opening, by the processing circuitry, the first closed contactor prior the second closed contactor in response to that the health level of the first closed contactor deviates from the mean health level of all contactors with a percentage rate higher than the deviation of the measured current of the second closed contactor from the mean measured current of all contactors.

14. A computer program product comprising program code for performing, when executed by the processing circuitry, the method of any of claims 11-13.

15. A non-transitory computer-readable storage medium comprising instructions, which when executed by the processing circuitry, cause the processing circuitry to perform the method of any of claims 11-13.
